# EUROPEAN PATENT APPLICATION

(11) **EP 3 950 875 A1**
(43) Date of publication of application: **09.02.2022**
(21) Application number: 20776335.0
(22) Date of filing: 25.03.2020
(51) Int. Cl.: C09K 3/14, B24B 37/00, H01L 21/304

(54) **POLISHING COMPOSITION**

(30) Priority: 28.03.2019 JP 2019063741
(71) Applicant: Fujimi Incorporated, Kiyosu-shi, Aichi 452-8502 (JP)
(72) Inventor: TSUCHIYA, Kohsuke, Kiyosu-shi, Aichi 452-8502 (JP); ASADA, Maki, Kiyosu-shi, Aichi 452-8502 (JP); ICHITSUBO, Taiki, Kiyosu-shi, Aichi 452-8502 (JP)
(74) Representative: Grünecker Patent- und Rechtsanwälte PartG mbB
(86) International application number: PCT/JP2020/013389
(87) International publication number: WO 2020/196645

(57) **Abstract**

Provided is a polishing composition having excellent capability of reducing haze on the surface of an object to be polished. The polishing composition provided by the present invention includes an abrasive, a basic compound, a water-soluble polymer, and water. The water-soluble polymer includes at least a water-soluble polymer P1 and a water-soluble polymer P2. Here, the water-soluble polymer P1 is an acetalized polyvinyl alcohol-based polymer, and the water-soluble polymer P2 is a water-soluble polymer other than the acetalized polyvinyl alcohol-based polymer.

## Description

### Technical Field

The present invention relates to a polishing composition. The present application claims priority based on Japanese Patent Application No. 2019-63741 filed on March 28, 2019, the entire contents of which are incorporated herein by reference.

### Background Art

Precision polishing using a polishing composition is performed on the surface of a material such as a metal, a metalloid, a non-metal, and an oxide thereof, or the like. For example, the surface of a silicon wafer used as a component of a semiconductor device and the like is generally finished into a high-quality mirror surface through a lapping step (rough polishing step) and a polishing step (fine polishing step). The polishing steps typically include a stock polishing step and a final polishing step. Patent Literature 1 to 3 are cited as technical literature on polishing compositions mainly used for application to polish semiconductor substrates such as silicon wafers.

### Citation List

### Patent Literature

Patent Literature 1: Japanese Patent No. 5891174
Patent Literature 2: Japanese Patent No. 6232243
Patent Literature 3: Japanese Patent No. 6185432

### Summary of Invention

### Technical Problem

In recent years, higher quality surfaces have been required for semiconductor substrates such as silicon wafers and other substrates. In particular, a polishing composition to be used in a final polishing step of a semiconductor substrate such as a silicon wafer or other substrate is required to be capable of yielding a surface showing excellent surface quality after polishing. In particular, there is a demand for a polishing composition that can yield a substrate surface having a lower haze.

Accordingly, an object of the present invention is to provide a polishing composition having excellent capability of reducing haze on the surface of an object to be polished. Solution to Problem

According to the present invention, there is provided a polishing composition including an abrasive, a basic compound, a water-soluble polymer, and water. The water-soluble polymer includes at least a water-soluble polymer P1 and a water-soluble polymer P2. Here, the water-soluble polymer P1 is an acetalized polyvinyl alcohol-based polymer. Further, the water-soluble polymer P2 is a water-soluble polymer other than the acetalized polyvinyl alcohol-based polymer.

Here, in the present specification, the "acetalized polyvinyl alcohol-based polymer" refers to a polymer in which at least some of hydroxyl groups contained in a polyvinyl alcohol-based polymer are acetalized. Thus, with a configuration including the water-soluble polymer P1, which is a polyvinyl alcohol-based polymer in which at least some of hydroxyl groups in the molecule are acetalized, together with the water-soluble polymer P2 which is another water-soluble polymer, a polishing composition having excellent capability of reducing haze on the surface of an object to be polished can be advantageously realized.

In a preferred embodiment of the polishing composition disclosed herein, the water-soluble polymer P1 is an acetalized polyvinyl alcohol-based polymer having a degree of acetalization of 1 mol% or more and less than 60 mol%. A polishing composition containing the acetalized polyvinyl alcohol-based polymer with a degree of acetalization in such a range and the water-soluble polymer P2 can exhibit more excellent haze reducing capability.

Here, in the present specification, the "degree of acetalization" refers to the ratio of acetalized structural units to all the repeating units constituting the acetalized polyvinyl alcohol-based polymer. The "acetalized structural unit" refers to a structural unit represented by a following general formula (1). 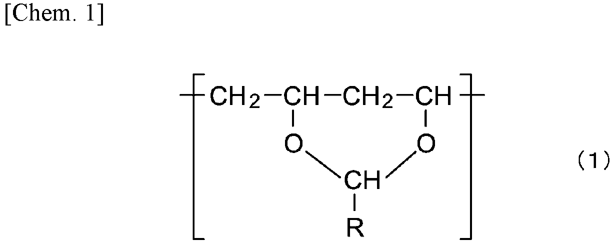 (In the formula (1), R is a hydrogen atom or a linear or branched alkyl group, and the alkyl group may be substituted with a functional group.)

In a preferred embodiment of the polishing composition disclosed herein, the water-soluble polymer P2 is one or two or more kinds selected from the group consisting of a nitrogen atom-containing polymer, a non-acetalized polyvinyl alcohol-based polymer, an oxyalkylene unit-containing polymer, a starch derivative, and a cellulose derivative. A polishing composition containing the water-soluble polymer P2 together with the acetalized polyvinyl alcohol-based polymer can exhibit further improved haze reducing capability.

In a preferred embodiment of the polishing composition disclosed herein, the polishing composition further contains a surfactant. With such a configuration, the surface to be polished is protected by the surfactant, so that the surface quality of the object to be polished is likely to be improved and the haze reducing capability is likely to be improved.

In a preferred embodiment of the polishing composition disclosed herein, the polishing composition contains two or more kinds of surfactants selected from the group consisting of a nonionic surfactant and an anionic surfactant. With such a configuration, the surface to be polished is easily and tightly protected by two or more kinds of surfactants which may have different properties in terms of adsorption on the surface to be polished, so that the surface quality of the object to be polished is easily improved and the haze reducing capability is improved.

In a preferred embodiment of the polishing composition disclosed herein, the surfactant includes a surfactant Sf_{S} having a weight average molecular weight of less than 1000 and a surfactant Sf_{L} having a weight average molecular weight of 1000 or more. With such a configuration, the surface to be polished is likely to be more tightly protected by the surfactant Sf_{S} and the surfactant Sf_{L}, which may have different properties in terms of adsorption on the surface to be polished, so that the surface quality of the object to be polished is likely to be improved.

In a preferred embodiment of the polishing composition disclosed herein, the weight average molecular weight of the water-soluble polymer P1 is 10 × 10⁴ or less. An acetalized polyvinyl alcohol-based polymer having an excessively large weight average molecular weight may not have a sufficient effect on the substrate surface. Therefore, where an acetalized polyvinyl alcohol-based polymer having a weight average molecular weight of less than or equal to the predetermined value is used, the effect of the acetalized polyvinyl alcohol-based polymer on the substrate surface is improved, and the haze reducing capability is likely to be improved.

In another preferred embodiment of the polishing composition disclosed herein, the abrasive is a silica particle. In polishing using a silica particle as the abrasive, haze reducing capability can be more effectively exhibited while maintaining the polishing removal rate.

A polishing composition according to a preferred embodiment disclosed herein is used for polishing a surface of silicon. The polishing composition disclosed herein can exhibit excellent haze reducing capability in polishing where the object to be polished is a surface made of silicon.

### Description of Embodiments

Preferred embodiments of the present invention will be described below. Incidentally, matters other than matters particularly mentioned in the present specification and necessary for the implementation of the present invention can be grasped as design matters of those skilled in the art based on the prior art in the relevant field. The present invention can be carried out based on the contents disclosed in this specification and technical common sense in the field.

### <Abrasive>

The polishing composition disclosed herein contains an abrasive. The abrasive serves to mechanically polish the surface of the object to be polished. The material and properties of the abrasive are not particularly limited, and can be selected, as appropriate, depending on the purpose and mode of use of the polishing composition. Examples of the abrasive include inorganic particles, organic particles, and organic-inorganic composite particles. Specific examples of the inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, red iron oxide particles and the like; nitride particles such as silicon nitride particles, boron nitride particles and the like; carbide particles such as silicon carbide particles, boron carbide particles and the like; diamond particles; carbonates such as calcium carbonate, barium carbonate and the like; and the like. Specific examples of the organic particles include polymethyl methacrylate (PMMA) particles, poly(meth)acrylic acid particles (herein, (meth)acrylic acid means to be inclusive of acrylic acid and methacrylic acid), polyacrylonitrile particles and the like. Such abrasives may be used singly or in combination of two or more kinds thereof.

As the abrasive, inorganic particles are preferable, and among them, those composed of oxides of metals or metalloids are preferable, and silica particles are particularly preferable. In a polishing composition that can be used for polishing (for example, final polishing) an object to be polished having a surface made of silicon, such as a silicon wafer described hereinbelow, it is particularly meaningful to use silica particles as the abrasive. The art disclosed herein can be preferably implemented, for example, in an embodiment in which the abrasive is substantially composed of silica particles. Here, "substantially" means that 95% by weight or more (preferably 98% by weight or more, more preferably 99% by weight or more, and may be 100% by weight) of the particles constituting the abrasive are silica particles.

Specific examples of silica particles include colloidal silica, fumed silica, precipitated silica and the like. The silica particles may be used singly or in combination of two or more kinds. The use of colloidal silica is particularly preferable, since a polished surface excellent in surface quality can be easily obtained after polishing. For example, colloidal silica prepared by an ion exchange method using water glass (Na silicate) as a raw material and alkoxide method colloidal silica (colloidal silica produced by a hydrolytic condensation reaction of an alkoxysilane) can be preferably used. Colloidal silica may be used singly or in combination of two or more kinds.

The true specific gravity of the material constituting the abrasive (for example, silica constituting silica particles) is preferably 1.5 or more, more preferably 1.6 or more, and even more preferably 1.7 or more. The upper limit of the true specific gravity of the material constituting the abrasive (for example, silica) is not particularly limited, but is typically 2.3 or less, for example, 2.2 or less. A measured value obtained by a liquid displacement method using ethanol as a liquid can be used as the true specific gravity of the abrasive (for example, silica particles).

The BET diameter of the abrasive (typically, silica particles) is not particularly limited, but is preferably 5 nm or more and more preferably 10 nm or more from the viewpoint of polishing removal rate and the like. From the viewpoint of obtaining a higher polishing effect (for example, effects such as haze reduction and defect removal), the BET diameter is preferably 15 nm or more, and more preferably 20 nm or more (for example, more than 20 nm). Further, from the viewpoint of reducing scratches and the like, the BET diameter of the abrasive is preferably 100 nm or less, more preferably 50 nm or less, and still more preferably 40 nm or less. The art disclosed herein is preferably applied to polishing in which a high-quality surface is required after polishing because a high-quality surface (for example, a surface having a small number of LPDs) can be easily obtained. As the abrasive to be used in such a polishing composition, an abrasive having a BET diameter of 35 nm or less (typically less than 35 nm, more preferably 32 nm or less, for example, less than 30 nm) is preferable.

In the present specification, the BET diameter refers to the particle diameter calculated by the formula of BET diameter (nm) = 6000/(true density (g/cm³) × BET value (m²/g)) from the specific surface area (BET value) measured by the BET method. For example, in the case of silica particles, the BET diameter can be calculated from BET diameter (nm) = 2727/BET value (m²/g). The specific surface area can be measured, for example, by using a surface area measuring device "Flow Sorb II 2300" (trade name) manufactured by Micromeritex Co., Ltd.

The shape (outer shape) of the abrasive may be globular or non-globular. Specific examples of non-globular particles include particles of a peanut shape (that is, the shape of a peanut shell), a cocoon shape, a conpeito shape, a rugby ball shape and the like. For example, an abrasive in which most of the particles have a peanut shape or a cocoon shape can be preferably used.

Although not particularly limited, the average value of the major axis/minor axis ratio (average aspect ratio) of the abrasive is in principle 1.0 or more, preferably 1.05 or more, and more preferably 1.1 or more. By increasing the average aspect ratio, it is possible to achieve higher polishing removal rate. From the viewpoint of reducing scratches and the like, the average aspect ratio of the abrasive is preferably 3.0 or less, more preferably 2.0 or less, and even more preferably 1.5 or less.

The shape (outer shape) and the average aspect ratio of the abrasive can be grasped by, for example, observation with an electron microscope. A specific procedure for grasping the average aspect ratio includes, for example, drawing a minimum rectangle circumscribing each particle image for a predetermined number (for example, 200 particles) of abrasive particles for which the shape of an independent particle can be recognized by using a scanning electron microscope (SEM). Then, with respect to the rectangle drawn for each particle image, a value obtained by dividing the length of the longer side (a value of a major axis) by the length of the shorter side (a value of the minor axis) is calculated as the value of the major axis/the value of the minor axis ratio (the aspect ratio). By arithmetically averaging the aspect ratios of the predetermined number of particles, the average aspect ratio can be obtained.

### <Water-Soluble Polymer>

The polishing composition disclosed herein contains a water-soluble polymer. As the water-soluble polymer, a polymer having at least one functional group selected from a cationic group, an anionic group and a nonionic group in the molecule can be used singly or in combination of two or more kinds thereof. More specifically, for example, one or two or more kinds of polymers selected from polymers having a hydroxyl group, a carboxy group, an acyloxy group, a sulfo group, a primary amide structure, a heterocyclic structure, a vinyl structure, a polyoxyalkylene structure and the like in the molecule can be used as the water-soluble polymer. In one embodiment, a nonionic polymer can be preferably used as the water-soluble polymer from the viewpoint of reducing aggregates, improving the cleaning performance and the like.

### (Water-Soluble Polymer PI)

The polishing composition in the art disclosed herein contains a water-soluble polymer P1, which is a polyvinyl alcohol-based polymer in which some of hydroxyl groups in the molecule are acetalized (hereinafter, referred to as "acetalized polyvinyl alcohol-based polymer"), as the water-soluble polymer. A polishing composition containing such a water-soluble polymer P1 together with a water-soluble polymer P2 described in detail hereinbelow can be excellent in haze reducing capability.

The acetalized polyvinyl alcohol-based polymer can be obtained by reacting some of the hydroxyl groups of the polyvinyl alcohol-based polymer with an aldehyde compound or a ketone compound to acetalize. Typically, the acetalized polyvinyl alcohol-based polymer is obtained by an acetalization reaction of the polyvinyl alcohol-based polymer and an aldehyde compound. In a preferred embodiment of the art disclosed herein, the acetalized polyvinyl alcohol-based polymer is a water-soluble polymer obtained by an acetalization reaction of a non-modified polyvinyl alcohol-based polymer and an aldehyde compound described hereinbelow.

### (Polyvinyl Alcohol-Based Polymer)

In the present specification, the polyvinyl alcohol-based polymer refers to a polymer containing a vinyl alcohol unit as a repeating unit thereof. The vinyl alcohol unit (hereinafter, also referred to as "VA unit") is a structural portion represented by the following chemical formula: -CH₂-CH(OH)-. Here, the non-modified polyvinyl alcohol refers to a polyvinyl alcohol-based polymer that is produced by hydrolyzing (saponifying) polyvinyl acetate and contains substantially no repeating units (-CH₂-CH(OCOCH₃)-) of the structure in which vinyl acetate is vinyl-polymerized or repeating units other than the VA unit. The degree of saponification of the non-modified PVA may be, for example, 60% or more, and from the viewpoint of solubility in water, the degree of saponification may be 70% or more, 80% or more, or 90% or more.

In the art disclosed herein, a non-modified PVA may be used, or a modified PVA may be used as the polyvinyl alcohol-based polymer to be used for producing the acetalized polyvinyl alcohol-based polymer. In a preferred embodiment of the art disclosed herein, one or two or more kinds of only non-modified PVA can be used as the polyvinyl alcohol-based polymer.

### (Aldehyde Compound)

In the art disclosed herein, the aldehyde compound used to produce the acetalized polyvinyl alcohol-based polymer is not particularly limited. In a preferred embodiment, the aldehyde compound has 1 to 7 carbon atoms, more preferably 2 to 7 carbon atoms.

Examples of the aldehyde compound include formaldehyde; linear or branched alkylaldehydes such as acetaldehyde, propionaldehyde, n-butylaldehyde, isobutylaldehyde, t-butylaldehyde, hexylaldehyde and the like; alicyclic or aromatic aldehydes such as cyclohexanecarbaldehyde, benzaldehyde and the like; and the like. These may be used singly or in combination of two or more. Further, except for formaldehyde, one or more hydrogen atoms may be substituted with halogen or the like. Of these, straight-chain or branched alkylaldehydes are preferable because they are highly soluble in water and easy to acetalize, and among them, acetaldehyde, n-propylaldehyde, n-butyraldehyde, and n-pentylaldehyde are more preferable.

As the aldehyde compound, in addition to the above, an aldehyde compound having 8 or more carbon atoms such as 2-ethylhexyl aldehyde, nonyl aldehyde, decyl aldehyde and the like may be used.

### (Structure of Acetalized Polyvinyl Alcohol-Based Polymer)

In the art disclosed herein, the acetalized polyvinyl alcohol-based polymer contains a VA unit which is a structural portion represented by the following chemical formula: -CH₂-CH (OH)-, and a structural unit (hereinafter, also referred to as "VAC unit") represented by the following general formula (1):

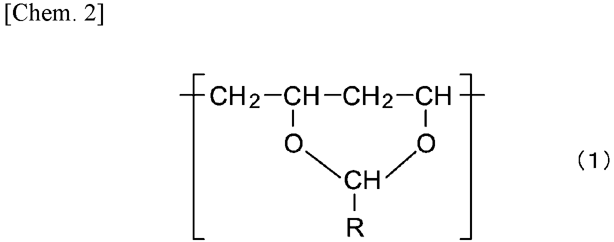

(In the formula (1), R is a hydrogen atom or a linear or branched alkyl group, and the alkyl group may be substituted with a functional group.)

In a preferred embodiment of the art disclosed herein, R in the above formula (1) is a hydrogen atom or a linear or branched alkyl group having 1 to 6 carbon atoms. R may be one of these, or a combination of two or more. From the viewpoint of improving the haze reducing capability, R is preferably a linear or branched alkyl chain having 1 to 6 carbon atoms.

In a preferred embodiment of the art disclosed herein, the acetalized polyvinyl alcohol-based polymer contains the VAC unit represented by the above formula (1) in the molecule in a proportion of 1 mol% or more and less than 60 mol%. (In other words, in a preferred embodiment, the degree of acetalization of the acetalized polyvinyl alcohol-based polymer is 1 mol% or more and less than 60 mol%). Where an acetalized polyvinyl alcohol-based polymer having a degree of acetalization of 1 mol% or more is used, a combination thereof with the water-soluble polymer P2 described in detail hereinbelow exhibit excellent haze reducing capability. Further, where the degree of acetalization is more than 60 mol%, the solubility of the acetalized polyvinyl alcohol-based polymer in water tends to be insufficient, which may adversely affect the haze reducing capability.

From the viewpoint of improving the haze reducing capability, the degree of acetalization of the acetalized polyvinyl alcohol-based polymer can be 5 mol% or more, preferably 10 mol% or more, more preferably 15 mol% or more, still more preferably 20 mol% or more, and particularly preferably 25 mol% or more (for example, 27 mol% or more). From the viewpoint of improving hydrophilicity, the degree of acetalization of the acetalized polyvinyl alcohol-based polymer is preferably 50 mol% or less, more preferably 40 mol% or less, and particularly preferably 35 mol% or less (for example, 33 mol% or less).

The weight average molecular weight (Mw) of the acetalized polyvinyl alcohol-based polymer used in the polishing composition disclosed herein is not particularly limited. The Mw of the acetalized polyvinyl alcohol-based polymer is usually suitably 100 × 10⁴ or less, preferably 30 × 10⁴ or less, and may be 20 × 10⁴ or less (for example, 10 × 10⁴ or less). From the viewpoint of surface protection of the object to be polished, the Mw of the acetalized polyvinyl alcohol-based polymer may be 5 × 10⁴ or less, 3 × 10⁴ or less, or 2 × 10⁴ or less. Further, from the viewpoint of improving the polishing removal rate, the Mw of the acetalized polyvinyl alcohol-based polymer is usually 4 × 10³ or more, may be 1 × 10⁴ or more, or may be 1.2 × 10⁴ or more.

In the present specification, a value based on water-based gel permeation chromatography (GPC) (water-based, polyethylene oxide equivalent) can be adopted as the weight average molecular weight (Mw) of the water-soluble polymer and the surfactant. A model "HLC-8320GPC" manufactured by Tosoh Corporation may be used as a GPC measuring device. The measurement conditions may be as described hereinbelow. Further, a value obtained by calculation can be adopted as the weight average molecular weight (Mw) of the surfactant. The same method is adopted for the examples described hereinbelow.

### [GPC Measurement Conditions]

Sample concentration: 0.1% by weight
Column: TSKgel GMPW_{XL}
Detector: differential refractometer
Eluent: 100 mM sodium nitrate aqueous solution/acetonitrile = 10 to 8/0 to 2
Flow velocity: 1 mL/min
Measurement temperature: 40°C
Sample injection amount: 200 µL

The content of the water-soluble polymer P1 in the polishing composition is not particularly limited and can be 0.0001% by weight or more, for example 0.0005% by weight or more. From the viewpoint of obtaining more excellent haze reducing capability, the preferable content is 0.001% by weight or more, more preferably 0.002% by weight or more, and further preferably 0.003% by weight or more. Further, the content of the water-soluble polymer P1 in the polishing composition can be, for example, 1.0% by weight or less. From the viewpoint of obtaining a removal ability suitable for the polishing step in which the polishing composition disclosed herein is used, a suitable content of the water-soluble polymer P1 is usually 0.1% by weight or less and preferably 0.05% by weight or less. From the viewpoint of obtaining a higher removal ability, the content may be 0.02% by weight or less, 0.01% by weight or less, or 0.008% by weight or less.

Although not particularly limited, a suitable content of the water-soluble polymer P1 with respect to 100 g of the abrasive contained in the polishing composition can be, for example, 0.1 g or more, and usually 0.2 g or more. From the viewpoint of obtaining more excellent haze reducing capability, the content of the water-soluble polymer P1 with respect to 100 g of the abrasive contained in the polishing composition is preferably 0.5 g or more, more preferably 1.0 g or more, and may be 2.0 g or more. Further, from the viewpoint of obtaining a removal ability suitable for the polishing step in which the polishing composition disclosed herein is used, a suitable content of the water-soluble polymer P1 with respect to 100 g of the abrasive contained in the polishing composition is usually 50 g or less, and preferably 30 g or less. From the viewpoint of obtaining a higher removal ability, the content of the water-soluble polymer P1 with respect to 100 g of the abrasive may be 10 g or less, or 5 g or less.

### (Water-Soluble Polymer P2)

As a water-soluble polymer, the polishing composition disclosed herein further contains the water-soluble polymer P2 in addition to the water-soluble polymer P1 described hereinabove. Here, the water-soluble polymer P2 is a water-soluble polymer other than the acetalized polyvinyl alcohol-based polymer.

Examples of the water-soluble polymer P2 include a cellulose derivative, a starch derivative, a polymers containing an oxyalkylene unit, a non-acetalized polyvinyl alcohol-based polymer, and a polymer containing a nitrogen atom. Of these, a polymer containing a nitrogen atom, a cellulose derivative, and a non-acetalized polyvinyl alcohol-based polymer are preferable.

The cellulose derivative is a polymer containing a β-glucose unit as the main repeating unit. Specific examples of the cellulose derivative include hydroxyethyl cellulose (HEC), hydroxypropyl cellulose, hydroxyethyl methyl cellulose, hydroxypropyl methyl cellulose, methyl cellulose, ethyl cellulose, ethyl hydroxyethyl cellulose, carboxymethyl cellulose and the like. Among these, HEC is preferred.

The starch derivative is a polymer containing an α-glucose unit as the main repeating unit. Specific examples of the starch derivative include pregelatinized starch, pullulan, carboxymethyl starch, cyclodextrin and the like. Among them, pullulan is preferred.

Examples of the polymer containing an oxyalkylene unit include polyethylene oxide (PEO), a block copolymer of ethylene oxide (EO) and propylene oxide (PO) or butylene oxide (BO), a random copolymer of EO and PO or BO and the like. Among them, a block copolymer of EO and PO or a random copolymer of EO and PO is preferable. The block copolymer of EO and PO may be a diblock copolymer, a triblock copolymer, and the like containing PEO blocks and polypropylene oxide (PPO) blocks. Examples of the triblock copolymer include a PEO-PPO-PEO triblock copolymer and a PPO-PEO-PPO triblock copolymer. Usually, a PEO-PPO-PEO triblock copolymer is more preferable.

Unless otherwise specified, the term copolymer in the present specification comprehensively refers to various copolymers such as random copolymers, alternating copolymers, block copolymers, graft copolymers and the like.

From the viewpoint of solubility in water, cleanability, and the like, in a block copolymer or random copolymer of EO and PO, the molar ratio (EO/PO) of EO to PO constituting the copolymer is preferably more than 1, more preferably 2 or more, and even more preferably 3 or more (for example, 5 or more).

The non-acetalized polyvinyl alcohol-based polymer is typically a polymer containing no acetalized structural unit (VAC unit) represented by the general formula (1) while being a polymer containing a vinyl alcohol unit (VA unit) as the main repeating unit. A polyvinyl alcohol-based polymer that can be used as the water-soluble polymer P2 in the art disclosed herein will be described hereinbelow.

### (Polyvinyl Alcohol-Based Polymer)

In the present specification, the polyvinyl alcohol-based polymer refers to a polymer containing a vinyl alcohol unit as a repeating unit thereof. The vinyl alcohol unit (hereinafter, also referred to as "VA unit") is a structural portion represented by the following chemical formula: -CH₂-CH(OH)-. The polyvinyl alcohol-based polymer may contain only a VA unit as a repeating unit, and may contain a repeating unit other than the VA unit (hereinafter, also referred to as "non-VA unit") in addition to the VA unit. The polyvinyl alcohol-based polymer may be a random copolymer containing a VA unit and a non-VA unit, and may be a block copolymer or a graft copolymer. The polyvinyl alcohol-based polymer may contain only one kind of non-VA unit, or may contain two or more kinds of non-VA units.

The polyvinyl alcohol-based polymer may be unmodified polyvinyl alcohol (non-modified PVA) or modified polyvinyl alcohol (modified PVA). Here, the non-modified PVA refers to a polyvinyl alcohol-based polymer that contains substantially no repeating units (-CH₂-CH(OCOCH₃)-) of the structure in which vinyl acetate is vinyl-polymerized or repeating units other than the VA unit. The degree of saponification of the non-modified PVA may be, for example, 60% or more, and from the viewpoint of water solubility, the degree of saponification may be 70% or more, 80% or more, or 90% or more.

The polyvinyl alcohol-based polymer may be a modified PVA that contains a VA unit and a non-VA unit having at least one structure selected from an oxyalkylene group, a carboxy group, a sulfo group, an amino group, a hydroxyl group, an amide group, an imide group, a nitrile group, an ether group, an ester group, and salts thereof. The non-VA unit that can be contained in the modified PVA may be, for example, a repeating unit derived from an N-vinyl type monomer or an N-(meth)acryloyl type monomer, which will be described hereinbelow, a repeating unit derived from ethylene, a repeating unit derived from an alkyl vinyl ether, a repeating unit derived from a vinyl ester of a monocarboxylic acid having 3 or more carbon atoms and the like, but are not limited to these examples. A preferred example of the N-vinyl type monomer is N-vinyl pyrrolidone. A preferred example of the N-(meth)acryloyl type monomer is N-(meth)acryloyl morpholine. The alkyl vinyl ether may be, for example, a vinyl ether having an alkyl group having 1 or more and 10 or less carbon atoms, such as propyl vinyl ether, butyl vinyl ether, 2-ethylhexyl vinyl ether and the like. The vinyl ester of a monocarboxylic acid having 3 or more carbon atoms may be, for example, a vinyl ester of a monocarboxylic acid having 3 or more carbon atoms and 7 or less carbon atoms, such as vinyl propanoate, vinyl butanoate, vinyl pentanate, vinyl hexanoate and the like. A cationically modified polyvinyl alcohol into which a cationic group such as a quaternary ammonium structure has been introduced may be used as the polyvinyl alcohol-based polymer. Examples of the cationically modified polyvinyl alcohol include compounds into which a cationic group derived from a monomer having a cationic group such as diallyldialkylammonium salt and N-(meth)acryloylaminoalkyl-N,N,N-trialkylammonium salt has been introduced.

The proportion of the number of moles of VA units to the number of moles of all repeating units constituting the polyvinyl alcohol-based polymer may be, for example, 5% or more, 10% or more, 20% or more, or 30% or more. Although not particularly limited, in some embodiments, the proportion of the number of moles of the VA unit may be 50% or more, 65% or more, 75% or more, 80% or more, and 90% or more (for example, 95% or more, or 98% or more). Substantially 100% of the repeating units constituting the polyvinyl alcohol-based polymer may be VA units. Here, "substantially 100%" means that the polyvinyl alcohol-based polymer does not contain non-VA units at least intentionally, and typically the proportion of the number of moles of non-VA units in the total number of moles of repeating units is less than 2% (for example, less than 1%), including the case of 0%. In some other embodiments, the proportion of the number of moles of VA units to the number of moles of all repeating units constituting the polyvinyl alcohol polymer may be, for example, 95% or less, 90% or less, or 80% or less, and 70% or less.

The content (content based on weight) of VA units in the polyvinyl alcohol-based polymer may be, for example, 5% by weight or more, 10% by weight or more, 20% by weight or more, or 30% by weight or more. Although not particularly limited, in some embodiments, the content of the VA unit may be 50% by weight or more (for example, more than 50% by weight), 70% by weight or more, or 80% by weight or more (for example, 90% by weight or more, 95% by weight or more, or 98% by weight or more). Substantially 100% by weight of the repeating units constituting the polyvinyl alcohol-based polymer may be VA units. Here, "substantially 100% by weight" means that the non-VA units are not contained, at least intentionally, as repeating units constituting the polyvinyl alcohol-based polymer, and typically, the content of the non-VA units in the polyvinyl alcohol-based polymer is less than 2% by weight (for example, less than 1% by weight). In some other embodiments, the content of VA units in the polyvinyl alcohol-based polymer may be, for example, 95% by weight or less, 90% by weight or less, 80% by weight or less, or 70% by weight or less.

The polyvinyl alcohol-based polymer may contain a plurality of polymer chains having different contents of the VA unit in the same molecule. Here, the polymer chain refers to a portion (segment) that constitutes a part of one molecule of polymer. For example, a polyvinyl alcohol-based polymer may have a polymer chain A with the content of the VA unit of more than 50% by weight and a polymer chain B with the content of the VA unit of less than 50% by weight (that is, the content of a non-VA unit is more than 50% by weight).

The polymer chain A may contain only a VA unit as a repeating unit, and may contain a non-VA unit in addition to the VA unit. The content of VA units in the polymer chain A may be 60% by weight or more, 70% by weight or more, 80% by weight or more, or 90% by weight or more. In some embodiments, the content of VA units in the polymer chain A may be 95% by weight or more, or 98% by weight or more. Substantially 100% by weight of the repeating units constituting the polymer chain A may be VA units.

The polymer chain B may contain only a non-VA unit as a repeating unit, and may contain a non-VA unit in addition to the VA unit. The content of non-VA units in the polymer chain B may be 60% by weight or more, 70% by weight or more, 80% by weight or more, or 90% by weight or more. In some embodiments, the content of non-VA units in the polymer chain B may be 95% by weight or more, or 98% by weight or more. Substantially 100% by weight of the repeating units constituting the polymer chain B may be non-VA units.

Examples of the polyvinyl alcohol-based polymer containing a polymer chain A and a polymer chain B in the same molecule include a block copolymer and a graft copolymer containing these polymer chains. The graft copolymer may be a graft copolymer having a structure in which a polymer chain B (side chain) is grafted on a polymer chain A (main chain), or a graft copolymer having a structure in which a polymer chain A (side chain) is grafted on a polymer chain B (main chain). In one embodiment, a polyvinyl alcohol-based polymer having a structure in which a polymer chain B is grafted on a polymer chain A can be used.

Examples of the polymer chain B include a polymer chain having a repeating unit derived from an N-vinyl type monomer as a main repeating unit, a polymer chain having a repeating unit derived from an N-(meth)acryloyl type monomer as a main repeating unit, a polymer chain having an oxyalkylene unit as a main repeating unit and the like. Unless otherwise specified, the main repeating unit in the present specification means a repeating unit contained in excess of 50% by weight.

A preferred example of the polymer chain B is a polymer chain having an N-vinyl type monomer as a main repeating unit, that is, an N-vinyl-based polymer chain. The content of the repeating unit derived from the N-vinyl type monomer in the N-vinyl polymer chain is typically more than 50% by weight, may be 70% by weight or more, may be 85% by weight or more, and may be 95% by weight or more. Substantially the entire polymer chain B may be of a repeating unit derived from an N-vinyl type monomer.

In the present specification, examples of the N-vinyl type monomer include monomers having a nitrogen-including heterocycle (for example, a lactam ring) and N-vinyl chain amides. Specific examples of the N-vinyl lactam type monomer include N-vinyl pyrrolidone, N-vinyl piperidone, N-vinyl morpholinone, N-vinyl caprolactam, N-vinyl-1,3-oxazine-2-one, and N-vinyl-3,5-morpholindione and the like. Specific examples of the N-vinyl chain amide include N-vinyl acetamide, N-vinyl propionic acid amide, N-vinyl butyric acid amide and the like. The polymer chain B is, for example, an N-vinyl-based polymer chain in which more than 50% by weight (for example, 70% by weight or more, 85% by weight or more, or 95% by weight or more) of the repeating unit is an N-vinyl pyrrolidone unit. Substantially all of the repeating units constituting the polymer chain B may be N-vinyl pyrrolidone units.

Another example of the polymer chain B is a polymer chain having a repeating unit derived from an N-(meth)acryloyl type monomer as a main repeating unit, that is, an N-(meth)acryloyl-based polymer chain. The content of the repeating unit derived from the N-(meth)acryloyl type monomer in the N-(meth)acryloyl polymer chain is typically more than 50% by weight, may be 70% by weight or more, may be 85% by weight or more, and may be 95% by weight or more. Substantially the entire polymer chain B may be of a repeating unit derived from an N-(meth)acryloyl type monomer.

In the present specification, examples of the N-(meth)acryloyl type monomer include a chain amide having an N-(meth)acryloyl group and a cyclic amide having an N-(meth)acryloyl group. Examples of the chain amide having an N-(meth)acryloyl group include (meth)acrylamide; an N-alkyl (meth)acrylamide such as N-methyl (meth)acrylamide, N-ethyl (meth)acrylamide, N-propyl (meth)acrylamide, N-isopropyl (meth)acrylamide, N-n-butyl (meth)acrylamide and the like; an N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, N,N-di(n-butyl) (meth)acrylamide and the like; and the like. Examples of the cyclic amide having an N-(meth)acryloyl group include N-(meth)acryloyl morpholine, N-(meth)acryloyl pyrrolidine and the like.

Another example of the polymer chain B is a polymer chain containing an oxyalkylene unit as a main repeating unit, that is, an oxyalkylene polymer chain. The content of the oxyalkylene unit in the oxyalkylene polymer chain is typically more than 50% by weight, may be 70% by weight or more, may be 85% by weight or more, and may be 95% by weight or more. Substantially all of the repeating units contained in the polymer chain B may be oxyalkylene units.

Examples of the oxyalkylene unit include an oxyethylene unit, an oxypropylene unit, an oxybutylene unit and the like. Each such oxyalkylene unit can be a repeating unit derived from the corresponding alkylene oxide. The oxyalkylene units contained in the oxyalkylene polymer chain may be of one kind or of two or more kinds. For example, an oxyalkylene polymer chain may contain an oxyethylene unit and an oxypropylene unit in combination. In an oxyalkylene polymer chain containing two or more kinds of oxyalkylene units, those oxyalkylene units may be random copolymers of corresponding alkylene oxides, block copolymers or graft copolymers.

Still other examples of the polymer chain B include a polymer chain containing a repeating unit derived from an alkyl vinyl ether (for example, a vinyl ether having an alkyl group having 1 or more and 10 or less carbon atoms), a polymer chain containing a repeating unit derived from a monocarboxylic acid vinyl ester (for example, a vinyl ester of a monocarboxylic acid having 3 or more carbon atoms), a polymer chain into which a cationic group (for example, a cationic group having a quaternary ammonium structure) has been introduced and the like.

From the viewpoint of improving the haze reducing capability, the polyvinyl alcohol-based polymer as the water-soluble polymer P2 in the art disclosed herein is preferably a modified polyvinyl alcohol which is a copolymer including a VA unit and a non-VA unit. The degree of saponification of the polyvinyl alcohol-based polymer as the water-soluble polymer P2 is usually 50 mol% or more, preferably 65 mol% or more, more preferably 70 mol% or more, for example 75 mol% or more. In principle, the degree of saponification of the polyvinyl alcohol-based polymer is 100 mol% or less.

Non-limiting examples of the polymer containing a nitrogen atom include a polymer containing a monomer unit of an N-vinyl type; an imine derivative; a polymer containing a monomer unit of an N-(meth)acryloyl type; and the like.

Examples of the polymer containing a monomer unit of an N-vinyl type include polymers containing a repeating unit derived from a monomer having a nitrogen-containing heterocycle (for example, a lactam ring). Examples of such polymers include homopolymers and copolymers of N-vinyl lactam-type monomers (for example, a copolymer having a copolymerization ratio of the N-vinyl lactam-type monomer of more than 50% by weight), homopolymers and copolymers of N-vinyl chain amides (for example, a copolymer having a copolymerization ratio of the N-vinyl chain amide of more than 50% by weight) and the like.

Specific examples of the N-vinyl lactam type monomer (that is, a compound having a lactam structure and an N-vinyl group in one molecule) include N-vinyl pyrrolidone (VP), N-vinyl piperidone, N-vinyl morpholinone, N-vinyl caprolactam (VC), N-vinyl-1,3-oxazin-2-one, N-vinyl-3,5-morpholindione and the like. Specific examples of the polymer containing a monomer unit of the N-vinyl lactam type include polyvinyl pyrrolidone, polyvinyl caprolactam, a random copolymer of VP and VC, a random copolymer of VP and/or VC with another vinyl monomer (for example, an acrylic monomer, a vinyl ester monomer and the like), a block copolymer or a graft copolymer containing a polymer chain containing one or both of VP and VC and the like.

Specific examples of the N-vinyl chain amide include N-vinyl acetamide, N-vinyl propionic acid amide, N-vinyl butyric acid amide and the like.

Examples of the polymer containing a monomer unit of an N-(meth)acryloyl type include a homopolymer and a copolymer of an N-(meth)acryloyl-type monomer (typically, a copolymer having a copolymerization ratio of the N-(meth)acryloyl-type monomer of more than 50% by weight). Examples of the N-(meth)acryloyl-type monomer include a chain amide having an N-(meth)acryloyl group and a cyclic amide having an N-(meth)acryloyl group.

Examples of the chain amides having an N-(meth)acryloyl group include: (meth)acrylamide; an N-alkyl (meth)acrylamide such as N-methyl (meth)acrylamide, N-ethyl (meth)acrylamide, N-propyl (meth)acrylamide, N-isopropyl (meth)acrylamide, N-n-butyl (meth)acrylamide and the like; an N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, N,N-di(n-butyl) (meth)acrylamide and the like; and the like. Examples of the polymer containing a chain amide having an N-(meth)acryloyl group as a monomer unit include a homopolymer of N-isopropylacrylamide and a copolymer of N-isopropylacrylamide (for example, a copolymer having a copolymerization ratio of N-isopropylacrylamide of more than 50% by weight).

Examples of the cyclic amide having an N-(meth)acryloyl group include N-acryloyl morpholine, N-acryloyl thiomorpholine, N-acryloyl piperidine, N-acryloyl pyrrolidine, N-methacryloyl morpholine, N-methacryloyl piperidine, N-methacryloyl pyrrolidine and the like. Examples of the polymer containing a cyclic amide having an N-(meth)acryloyl group as a monomer unit include an acryloyl morpholine-based polymer (PACMO) and the like. Typical examples of the acryloyl morpholine-based polymer include a homopolymer of N-acryloyl morpholine (ACMO) and a copolymer of ACMO (for example, a copolymer having a copolymerization ratio of ACMO of more than 50% by weight). In the acryloyl morpholine-based polymer, the ratio of the number of moles of the ACMO unit to the number of moles of all repeating units is usually 50% or more and suitably 80% or more (for example, 90% or more, typically 95% or more). All the repeating units of the water-soluble polymer may be composed substantially of the ACMO unit.

The weight average molecular weight (Mw) of the water-soluble polymer P2 used in the polishing composition disclosed herein is not particularly limited. The Mw of the water-soluble polymer P2 is usually suitably 4 × 10³ or more, and may be 1 × 10⁴ or more, 5 × 10⁴ or more, 10 × 10⁴ or more, 20 × 10⁴ or more, 25 × 10⁴ or more, or 30 × 10⁴ or more. The Mw of the water-soluble polymer P2 is usually suitably 100 × 10⁴ or less, preferably 80 × 10⁴ or less, and may be 50 × 10⁴ or less (for example, 40 × 10⁴ or less).

In a preferred embodiment of the polishing composition disclosed herein, the weight average molecular weight of the water-soluble polymer P1 is smaller than the weight average molecular weight of the water-soluble polymer P2. By using an acetalized polyvinyl alcohol-based polymer having a relatively small weight average molecular weight in combination with another water-soluble polymer having a relatively large weight average molecular weight, the haze reducing capability can be further improved.

In the art disclosed herein, one kind of water-soluble polymer can be used alone as the water-soluble polymer P2, or two or more kinds of water-soluble polymers can be used in combination. Further, in one embodiment of the polishing composition disclosed herein, in addition to the water-soluble polymer P1 and the water-soluble polymer P2, one or two or more kinds of water-soluble polymers can be further included.

The content of the water-soluble polymer P2 in the polishing composition is not particularly limited, and can be, for example, 0.0005% by weight or more. From the viewpoint of obtaining more excellent haze reducing capability, the preferable content is 0.001% by weight or more, more preferably 0.0015% by weight or more, and further preferably 0.002% by weight or more. Further, the content of the water-soluble polymer P2 in the polishing composition can be, for example, 1.0% by weight or less. From the viewpoint of obtaining a removal ability suitable for the polishing step in which the polishing composition disclosed herein is used, the content of the water-soluble polymer P2 is usually suitably 0.1% by weight or less and preferably 0.05% by weight or less. From the viewpoint of obtaining a higher removal ability, the content may be 0.02% by weight or less, 0.01% by weight or less, or 0.005% by weight or less.

Although not particularly limited, the content of the water-soluble polymer P2 with respect to 100 g of the abrasive contained in the polishing composition can be, for example, 0.1 g or more, and this content is usually suitably 0.2 g or more. From the viewpoint of obtaining more excellent haze reducing capability, the content of the water-soluble polymer P2 with respect to 100 g of the abrasive contained in the polishing composition is preferably 0.5 g or more, more preferably 1.0 g or more, and may be 2.0 g or more. Further, from the viewpoint of obtaining a removal ability suitable for the polishing step in which the polishing composition disclosed herein is used, the content of the water-soluble polymer P2 with respect to 100 g of the abrasive contained in the polishing composition is usually suitably 50 g or less, and preferably 30 g or less. From the viewpoint of obtaining a higher removal ability, the content of the water-soluble polymer P2 with respect to 100 g of the abrasive may be 10 g or less, or 5 g or less.

Although not particularly limited, the ratio (P1/P2) of the content (% by weight) of the water-soluble polymer P1 to the content (% by weight) of the water-soluble polymer P2 in the polishing composition can be 0.01 or more, the ratio is usually suitably 0.1 or more, preferably 0.25 or more, and may be 0.5 or more, 0.8 or more, and 1 or more. The ratio (P1/P2) of the content (% by weight) of the water-soluble polymer P1 to the content (% by weight) of the water-soluble polymer P2 in the polishing composition is usually suitably 10 or less, preferably 5 or less, and may be 4 or less, 3 or less, or 2 or less. With the configuration including the water-soluble polymer P1 and the water-soluble polymer P2 in such a range, the haze reducing capability can be more effectively exhibited.

### <Surfactant>

In a preferred embodiment, the polishing composition disclosed herein may contain a surfactant. The surfactant can contribute to improving the dispersion stability of the polishing slurry or the concentrate thereof. The surfactant is not particularly limited, and any of an amphoteric surfactant, a cationic surfactant, an anionic surfactant and a nonionic surfactant can be used. Further, as the surfactant, for example, an organic compound having an Mw of less than 4000 can be used. From the viewpoint of filtration ability of the polishing slurry and the cleanability of the object to be polished, the Mw of the surfactant is preferably 3500 or less. Further, in a preferred embodiment of the art disclosed herein, the Mw of the surfactant is 100 or more, more preferably 200 or more, still more preferably 250 or more, and particularly preferably 300 or more. The polishing removal rate tends to increase with the increase in the Mw of the surfactant.

Examples of the surfactant include nonionic surfactants such as oxyalkylene polymers such as polyethylene glycol, polypropylene glycol, polytetramethylene glycol and the like, polyoxyalkylene adducts such as polyoxyethylene alkyl ethers, polyoxyethylene alkyl phenyl ethers, polyoxyethylene alkyl amines, polyoxyethylene fatty acid esters, polyoxyethylene glyceryl ether fatty acid esters, polyoxyethylene sorbitan fatty acid esters and the like, and copolymers of multiple types of oxyalkylenes (diblock type, triblock type, random type, alternating type) and the like.

Specific examples of the nonionic surfactant include block copolymers of ethylene oxide (EO) and propylene oxide (PO) (a diblock copolymer, a PEO (polyethylene oxide) - PPO (polypropylene oxide) - PEO triblock, a PPO-PEO-PPO triblock copolymer and the like), random copolymers of EO and PO, polyethylene oxide, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene 2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, polyoxyethylene styrenated phenyl ether, polyoxyethylene lauryl amine, polyoxyethylene stearyl amine, polyoxyethylene oleyl amine, polyoxyethylene stearyl amide, polyoxyethylene oleyl amide, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, polyoxyethylene hydrogenated castor oil, and the like. Among them, examples of preferred surfactants include a block copolymer of EO and PO (in particular, a PEO-PPO-PEO triblock copolymer) and a polyoxyethylene alkyl ether (for example, polyoxyethylene decyl ether).

Examples of the anionic surfactant include sulfate esters of polyoxyethylene alkyl ethers and salts thereof, sulfonic acids and salts thereof, carboxylic acids and salts thereof, and a phosphoric acid esters and salts thereof.

Specific examples of the anionic surfactant include polyoxyethylene lauryl ether sulfuric acid, polyoxyethylene myristyl ether sulfuric acid, polyoxyethylene palmityl ether sulfuric acid; sodium polyoxyethylene lauryl ether sulfate, ammonium polyoxyethylene lauryl ether sulfate, triethanolamine polyoxyethylene lauryl ether sulfate, sodium polyoxyethylene myristyl ether sulfate, ammonium polyoxyethylene myristyl ether sulfate, triethanolamine polyoxyethylene myristyl ether sulfate, sodium polyoxyethylene palmityl ether sulfate, amine polyoxyethylene palmityl ether sulfate, triethanolamine polyoxyethylene palmityl ether sulfate, polyoxyethylene octylsulfonic acid, polyoxyethylene dodecylsulfonic acid, polyoxyethylene cetylsulfonic acid, polyoxyethylene octylbenzenesulfonic acid, polyoxyethylene dodecylbenzenesulfonic acid; sodium polyoxyethylene octyl sulfonate, sodium polyoxyethylene dodecyl sulfonate, sodium polyoxyethylene cetyl sulfonate, polyoxyethylene lauryl ether acetic acid, polyoxyethylene tridecyl ether acetic acid, polyoxyethylene octyl ether acetic acid; sodium polyoxyethylene lauryl ether acetate, ammonium polyoxyethylene lauryl ether acetate, sodium polyoxyethylene tridecyl ether acetate, ammonium polyoxyethylene tridecyl ether acetate, sodium polyoxyethylene octyl ether acetate, ammonium polyoxyethylene octyl ether acetate, polyoxyethylene lauryl ether phosphoric acid, polyoxyethylene alkyl (12-15) ether phosphoric acid; sodium polyoxyethylene lauryl ether phosphate, sodium polyoxyethylene oleyl ether phosphate, sodium polyoxyethylene cetyl ether phosphate, potassium polyoxyethylene alkyl (12-15) ether phosphate, disodium polyoxyethylene lauryl sulfosuccinate, polyoxyethylene lauroyl ethanolamide disodium sulfosuccinate and the like.

In a preferred embodiment, the polishing composition disclosed herein contains two or more kinds of surfactants selected from the group consisting of nonionic surfactants and anionic surfactants. With such a configuration, the haze reducing capability tends to be further improved.

In a preferred embodiment of the art disclosed herein, the polishing composition may contain, as the surfactant, only two or more kinds of surfactants selected from nonionic surfactants. For example, as the surfactant, a polyoxyethylene alkyl ether and a copolymer of oxyethylene (EO) and oxypropylene (PO) can be used in combination. With such a configuration, haze reducing capability can be better exhibited.

In another preferred embodiment of the art disclosed herein, the polishing composition can contain one or two or more kinds of nonionic surfactants together with one or two or more kinds of anionic surfactants as the surfactant. For example, as the surfactant, a polyoxyethylene alkyl ether and a polyoxyethylene oxyalkyl ether sulfate can be used in combination.

In a preferred embodiment, the polishing composition contains a surfactant Sfs having a weight average molecular weight (Mw) of less than 1000 (typically 100 or more and less than 1000) and a surfactant Sf_{L} having a weight average molecular weight (Mw) of 1000 or more (typically 1000 or more and less than 1 × 10⁴). With such a configuration, the haze reducing capability can be further improved.

As the surfactant Sfs, one kind of the surfactant exemplified hereinabove can be used alone or two or more kinds thereof can be used in combination. Further, as the surfactant Sf_{L}, one kind of the surfactant exemplified hereinabove can be used alone or two or more kinds thereof can be used in combination. In a preferred embodiment, a polyoxyethylene alkyl ether can be used as the surfactant Sf_{S}. Further, a copolymer of oxyethylene (EO) and oxypropylene (PO) and/or a polyoxyethylene oxyalkyl ether sulfate can be used as the surfactant Sf_{L}.

The content of the surfactant in the polishing composition (when two or more kinds of surfactants are contained, the total content thereof) is not particularly limited, and can be, for example, 0.00001% by weight or more. From the viewpoint of obtaining more excellent haze reducing capability, the content is preferably 0.0001% by weight or more, and more preferably 0.0005% by weight or more. Further, the content (total content) of the surfactant in the polishing composition can be, for example, 0.05% by weight or less. From the viewpoint of obtaining a removal ability suitable for the polishing step in which the polishing composition disclosed herein is used, usually the content (total content) of the surfactant is suitably 0.01% by weight or less, preferably 0.005% by weight or less, and may be 0.003% by weight or less.

Although not particularly limited, the content of the surfactant (the total content when two or more kinds of surfactants are contained) per 100 g of the abrasive contained in the polishing composition is, for example, 0.005 g or more, and usually the content is suitably 0.01 g or more. From the viewpoint of obtaining more excellent haze reducing capability, the content (total content) of the surfactant with respect to 100 g of the abrasive contained in the polishing composition may be 0.05 g or more, or 0.1 g or more, and 0.2 g or more. Further, from the viewpoint of obtaining a removal ability suitable for the polishing step in which the polishing composition disclosed herein is used, the content (total content) of the surfactant with respect to 100 g of the abrasive contained in the polishing composition is determined. Usually, the content is suitably 10 g or less, preferably 5 g or less, and may be 2 g or less.

When the surfactant Sf_{S} and the surfactant Sf_{L} are used in combination as the surfactant, the ratio (Sf_{S}/Sf_{L}) of the content (% by weight) of the surfactant Sf_{S} to the content (% by weight) of the surfactant Sf_{L} is usually suitably 0.5 or more, preferably 1 or more, and more preferably 1.2 or more. In a preferred embodiment, Sf_{S}/Sf_{L} may be 1.5 or more, 1.8 or more, 2 or more, or 3 or more. From the viewpoint of utilizing the effect of using two or more kinds of surfactants having different Mw, the ratio Sf_{S}/Sf_{L} of the content of the surfactant Sfs to the content of the surfactant Sf_{L} is usually suitably 15 or less, preferably 10 or less, and more preferably 8 or less.

### <Water>

As the water contained in the polishing composition disclosed herein, ion exchange water (deionized water), pure water, ultrapure water, distilled water or the like can be preferably used. In order to minimize the inhibition of the action of other components contained in the polishing composition, it is preferable that the total content of transition metal ions in the water used be, for example, 100 ppb or less. For example, the purity of water can be increased by operations such as removal of impurity ions with ion exchange resin, removal of contaminants with a filter, by distillation and the like.

### <Basic Compound>

The polishing composition disclosed herein contains a basic compound. In the present specification, the term "basic compound" refers to a compound having a function of dissolving in water and raising the pH of the aqueous solution. As the basic compound, an organic or inorganic basic compound containing nitrogen, an alkali metal hydroxide, an alkaline earth metal hydroxide, a quaternary phosphonium compound, various carbonates, bicarbonates and the like can be used. Examples of nitrogen-containing basic compounds include quaternary ammonium compounds, ammonia, amines (preferably water-soluble amines) and the like. Such basic compounds may be used singly or in combination of two or more types thereof.

Specific examples of the alkali metal hydroxide include potassium hydroxide, sodium hydroxide and the like. Specific examples of the carbonate or bicarbonate include ammonium hydrogen carbonate, ammonium carbonate, potassium hydrogen carbonate, potassium carbonate, sodium hydrogen carbonate, sodium carbonate and the like. Specific examples of the amine include methylamine, dimethylamine, trimethylamine, ethylamine, diethylamine, triethylamine, ethylenediamine, monoethanolamine, N-((β-aminoethyl) ethanolamine, hexamethylenediamine, diethylenetriamine, triethylenetetramine, piperazine anhydride, piperazine hexahydrate, 1-(2-aminoethyl) piperazine, N-methylpiperazine, guanidine, azoles such as imidazole, triazole and the like. Specific examples of the quaternary phosphonium compound include a quaternary phosphonium hydroxide such as tetramethylphosphonium hydroxide, tetraethylphosphonium hydroxide and the like.

A quaternary ammonium salt (typically, a strong base) such as a tetraalkylammonium salt, a hydroxyalkyltrialkylammonium salt or the like can be preferably used as the quaternary ammonium compound. The anion component in such a quaternary ammonium salt can be, for example, OH⁻, F⁻, Cl⁻, Br⁻, I⁻, ClO₄⁻, BH₄⁻ and the like. Among them, a quaternary ammonium salt with OH⁻ as an anion, that is, a quaternary ammonium hydroxide can be mentioned as a preferable example. Specific examples of the quaternary ammonium hydroxide include a tetraalkylammonium hydroxide such as tetramethylammonium hydroxide, tetraethylammonium hydroxide, tetrapropylammonium hydroxide, tetrabutylammonium hydroxide, tetrapentylammonium hydroxide, tetrahexylammonium hydroxide and the like; a hydroxyalkyltrialkylammonium hydroxide such as 2-hydroxyethyltrimethylammonium hydroxide (also referred to as choline) and the like; and the like.

Among these basic compounds, for example, at least one basic compound selected from alkali metal hydroxide, quaternary ammonium hydroxides and ammonia can be preferably used. Among them, potassium hydroxide, a tetraalkylammonium hydroxide (for example, tetramethylammonium hydroxide) and ammonia are more preferable, and ammonia is particularly preferable.

### <Other Components>

In addition, the polishing composition disclosed herein may optionally contain a well-known additive that can be used in a polishing slurry (typically, a polishing slurry to be used in a step of polishing silicon wafers), such as a chelating agent, an organic acid, an organic acid salt, an inorganic acid, an inorganic acid salt, an antiseptic agent, an antifungal agent and the like, as long as the effects of the present invention are not significantly impaired.

It is preferable that the polishing composition disclosed herein contain substantially no oxidant. Where the polishing composition contains an oxidant, the supply of the composition oxidizes the surface of the object to be polished (typically, a silicon substrate) to form an oxide layer, which can decrease a polishing removal rate. Here, the polishing composition containing substantially no oxidant means that the oxidant is not blended at least intentionally, and a trace amount of the oxidant that is inevitably contained due to the raw materials, manufacturing method and the like is allowed to be present. The trace amount means that the molar concentration of the oxidant in the polishing composition is 0.0005 mol/L or less (preferably 0.0001 mol/L or less, more preferably 0.00001 mol/L or less, and particularly preferably 0.000001 mol/L or less). The polishing composition according to a preferred embodiment does not contain an oxidant. The polishing composition disclosed herein can be preferably implemented in an embodiment that does not contain, for example, hydrogen peroxide, sodium persulfate, ammonium persulfate and sodium dichloroisocyanurate.

### <pH>

The pH of the polishing composition disclosed herein is typically 8.0 or higher, preferably 8.5 or higher, more preferably 9.0 or higher, and still more preferably 9.3 or higher, for example 9.5 or more. When the pH of the polishing composition is increased, the polishing removal rate tends to be improved. Meanwhile, from the viewpoint of preventing the dissolution of the abrasive (for example, silica particles) and suppressing weakening of mechanical polishing effect, the pH of the polishing composition is suitably 12.0 or less, preferably 11.0 or less, more preferably 10.8 or less, and still more preferably 10.5 or less.

The pH can be grasped by performing three-point calibration using a standard buffer solution (a phthalate pH buffer solution, pH: 4.01 (at 25°C), a neutral phosphate pH buffer solution, pH: 6.86 (at 25°C), and a carbonate pH buffer solution, pH: 10.01 (at 25°C)) by using a pH meter (for example, a glass electrode type hydrogen ion concentration indicator manufactured by Horiba Ltd. (model number F-23)), then placing a glass electrode in the composition to be measured, and measuring a pH value after the composition has been stabilized for 2 min or longer.

### <Application>

The polishing composition in the art disclosed herein can be applied to objects to be polished that are made of various materials and have various shapes. The material of the object to be polished is, for example, a metal or metalloid such as silicon, aluminum, nickel, tungsten, copper, tantalum, titanium, stainless steel and the like and alloys thereof; a glassy substance such as quartz glass, aluminosilicate glass, glassy carbon and the like; a ceramic material such as alumina, silica, sapphire, silicon nitride, tantalum nitride, titanium carbide and the like; a compound semiconductor substrate material such as silicon carbide, gallium nitride, gallium arsenide and the like; a resin material such as polyimide resin and the like; and the like. The object to be polished may be configured of a plurality of the aforementioned materials.

The polishing composition in the art disclosed herein can be particularly preferably used for polishing a surface made of silicon (typically polishing a silicon wafer). A typical example of the silicon wafer referred to herein is a silicon single crystal wafer, for example, a silicon single crystal wafer obtained by slicing a silicon single crystal ingot.

The polishing composition disclosed herein can be preferably applied to a polishing step of an object to be polished (for example, a silicon wafer). The object to be polished may be subjected to general treatment which can be applied to the object to be polished in a step upstream of the polishing step, such as lapping, etching and the like, before the polishing step performed with the polishing composition disclosed herein.

The polishing composition disclosed herein can be preferably used, for example, in polishing an object (for example, a silicon wafer) prepared in pre-process to have a surface roughness of 0.1 nm to 100 nm. The surface roughness Ra of the object to be polished can be measured using, for example, a laser scan type surface roughness meter "TMS-3000WRC" manufactured by Schmitt Measurement System Inc. The polishing composition disclosed herein can be effectively used in final polishing or in polishing immediately therebefore, and is particularly preferably used in final polishing. The final polishing referred to herein is a final polishing step in the manufacturing process of the target product (that is, a process in which no further polishing is performed after this step).

### <Polishing Composition>

The polishing composition disclosed herein is typically supplied to an object to be polished in the form of a polishing slurry including the polishing composition to be used for polishing the object to be polished. The polishing slurry may be prepared, for example, by diluting (typically diluting with water) any of the polishing compositions disclosed herein. Alternatively, the polishing composition may be used as it is as a polishing slurry. That is, the concept of the polishing composition in the art disclosed herein is inclusive of both a polishing slurry (working slurry) supplied to the object to be polished and used for polishing the object to be polished, and the concentrate (that is, the stock solution of the polishing slurry) to be diluted and used as the polishing slurry. A polishing slurry obtained by adjusting the pH of the polishing composition is another example of the polishing slurry including the polishing composition disclosed herein.

### (Polishing Slurry)

The content of the abrasive in the polishing slurry is not particularly limited, but is typically 0.01% by weight or more, preferably 0.05% by weight or more, and more preferably 0.10% by weight or more, for example 0.15% by weight or more. Higher polishing removal rates can be achieved by increasing the content of the abrasive. From the viewpoint of dispersion stability of particles in the polishing slurry, the content of the abrasive in the polishing slurry is usually preferably 10% by weight or less, preferably 7% by weight or less, more preferably 5% by weight or less, further preferably 2% by weight or less, for example, 1% by weight or less, and may be 0.7% by weight or less. In a preferred embodiment, the content of the abrasive in the polishing slurry may be 0.5% by weight or less, or 0.2% by weight or less.

The concentration (total concentration) of the water-soluble polymer in the polishing slurry is not particularly limited, and can be, for example, 0.0001% by weight or more. From the viewpoint of haze reduction and the like, the preferable concentration is 0.0005% by weight or more, more preferably 0.001% by weight or more, for example 0.003% by weight or more, and may be 0.005% by weight or more. Further, from the viewpoint of polishing speed and the like, the concentration of the water-soluble polymer in the polishing slurry is usually preferably 0.2% by weight or less, more preferably 0.1% by weight or less, and may be 0.05% by weight or less (for example, 0.01% by weight or less).

The concentration of the basic compound in the polishing slurry is not particularly limited. From the viewpoint of improving the polishing speed, the concentration of the basic compound in the polishing slurry is usually preferably 0.001% by weight or more, and more preferably 0.003% by weight or more (for example, 0.005% by weight or more). Further, from the viewpoint of haze reduction and the like, the concentration of the basic compound in the polishing slurry is suitably less than 0.3% by weight, preferably less than 0.1% by weight, and more preferably less than 0.05% by weight (for example, less than 0.03% by weight).

### (Concentrate)

The polishing composition disclosed herein may be in a concentrated form (that is, in the form of a polishing slurry concentrate which can also be grasped as a stock polishing slurry) before being supplied to the object to be polished. The polishing composition in such a concentrated form is advantageous from the viewpoint of convenience, cost reduction and the like in production, distribution, storage and the like. The concentration factor is not particularly limited, and can be, for example, about 2 times to 100 times in terms of volume, and usually about 5 times to 50 times (for example, about 10 times to 40 times) is suitable.

Such a concentrate can be diluted at a desired timing to prepare a polishing slurry (working slurry) and used in the form of supplying the polishing slurry to an object to be polished. The dilution can be performed, for example, by adding water to the concentrate and mixing.

The content of the abrasive in the concentrate can be, for example, 50% by weight or less. From the viewpoint of handleability (for example, dispersion stability of abrasive and filterability) of the concentrate and the like, usually, the content of the abrasive in the concentrate is preferably 45% by weight or less, and more preferably 40% by weight or less. Further, from the viewpoint of convenience and cost reduction and the like in production, distribution, storage and the like, the content of the abrasive can be, for example, 0.5% by weight or more, preferably 1% by weight or more, and more preferably 3% by weight or more.

### (Preparation of Polishing Composition)

The polishing composition used in the art disclosed herein may be of a one-agent type or a multi-agent type such as a two-agent type. For example, the polishing slurry may be configured to be prepared by mixing Part A including at least the abrasive among the constituent components of the polishing slurry and Part B including the remaining components, and diluting as necessary at appropriate timing.

A method for preparing the polishing composition is not particularly limited. For example, the components constituting the polishing composition may be mixed using a known mixing device such as a blade type stirrer, an ultrasonic disperser, a homomixer or the like. The mode of mixing these components is not specifically limited. For example, all the components may be mixed at once, or may be mixed in a suitably set order.

### <Polishing>

The polishing composition disclosed herein can be used for polishing an object to be polished, for example, in a mode including the following operations. Hereinafter, a preferred embodiment of a method for polishing an object to be polished (for example, a silicon wafer) using the polishing composition disclosed herein will be described.

That is, a polishing slurry including any of the polishing compositions disclosed herein is prepared. The preparation of the polishing slurry may include preparing the polishing slurry by adding operations such as concentration adjustment (for example, dilution) and pH adjustment of the polishing composition. Alternatively, the polishing composition may be used as it is as a polishing slurry.

Then, the polishing slurry is supplied to the object to be polished and polishing is performed by a conventional method. For example, when performing final polishing of a silicon wafer, typically, the silicon wafer that has been subjected to lapping is set in a general polishing machine, and the polishing slurry is supplied to the surface to be polished of the silicon wafer through a polishing pad of the polishing machine. Typically, the polishing pad is pressed against the surface to be polished of the silicon wafer and the two are moved relative to each other (for example, rotationally movement) while the polishing slurry is continuously supplied. Polishing of the object to be polished is completed through such a polishing step.

The polishing pad used in the polishing step is not particularly limited. For example, a polishing pad of a polyurethane foam type, a non-woven fabric type, or a suede type can be used. Each polishing pad may or may not contain an abrasive. Usually, a polishing pad including no abrasive is preferably used.

The object polished using the polishing composition disclosed herein is typically cleaned. Cleaning can be performed using a suitable cleaning solution. The cleaning solution to be used is not particularly limited, and for example, SC-1 cleaning solution (a mixture of ammonium hydroxide (NH₄OH), hydrogen peroxide (H₂O₂) and water (H₂O)), SC-2 (mixed liquid of HCl, H₂O₂ and H₂O) or the like, which are common in the field of semiconductors and the like, can be used. The temperature of the cleaning solution can be, for example, in the range of room temperature (typically about 15°C to 25°C) or higher and up to about 90°C. From the viewpoint of improving the cleaning effect, a cleaning solution having a temperature of about 50°C to 85°C can be preferably used.

### Examples

Several examples relating to the present invention will be described below, but the present invention is not intended to be limited to these examples. In the following description, "part" and "%" unless specifically indicated otherwise.

### <Preparation of Polishing Composition>

### (Example 1)

A polishing composition containing an abrasive, an acetalized polyvinyl alcohol-based polymer, polyacryloylmorpholine (hereinafter referred to as "PACMO"), a basic compound, and a surfactant, with the balance being water, was prepared and taken as the polishing composition according to Example 1. Colloidal silica having a BET diameter of 25 nm was used as the abrasive. The BET diameter was measured using a surface area measuring device "Flow Sorb II 2300" (trade name) manufactured by Micromeritex Co., Ltd. The acetalized polyvinyl alcohol-based polymer had an Mw of 1.3 × 10⁴ and the degree of acetalization of 30 mol%. The PACMO had an Mw of 35 × 10⁴. As the surfactant, polyoxyethylene (the number of added moles of ethylene oxide was 5) decyl ether (hereinafter referred to as "C10PEO5") having a Mw of 378 was used. Ammonia was used as the basic compound. The content of each component in the polishing composition according to Example 1 was 0.17% for the abrasive, 0.0050% for the acetalized polyvinyl alcohol-based polymer, 0.0038% for PACMO, and 0.011% for the basic compound.

### (Example 2)

A polishing composition according to this example was prepared in the same manner as in Example 1 except that an acetalized polyvinyl alcohol-based polymer having an Mw of 6 × 10³ and a degree of acetalization of 10 mol% was used.

### (Example 3)

A polishing composition according to this example was prepared in the same manner as in Example 1 except that a polymer that had a Mw of 2.6 × 10⁴ and was acetalized at a degree of acetalization of 20 mol% was used as the acetalized polyvinyl alcohol-based polymer.

### (Example 4)

A polishing composition according to this example was prepared in the same manner as in Example 1 except that polyoxyethylene (the number of added moles of ethylene oxide was 18) ammonium lauryl ether sulfate (hereinafter referred to as "C12PEO18-SO3NH3") having a Mw of 1058 was used in addition to C10PEO5 as the surfactant, and the content of C12PEO18-SO3NH3 contained in the composition was 0.0002%.

### (Example 5)

A polishing composition according to this example was prepared in the same manner as in Example 1 except that a PEO-PPO-PEO type triblock copolymer having an Mw of 3200 (PPO at the center, PEO at both ends, hereinafter referred to as "PEO-PPO-PEO") was used in addition to C10PEO5 as the surfactant, and the content of PEO-PPO-PEO contained in the composition was 0.0004%. The molar ratio of EO units to PO units in the PEO-PPO-PEO was EO:PO = 85:15.

### (Example 6)

A polishing composition according to this example was prepared in the same manner as in Example 1 except that non-acetalized polyvinyl alcohol having a Mw of 7 × 10⁴ and a degree of saponification of 98 mol% or more was used instead of the acetalized polyvinyl alcohol-based polymer.

### (Example 7)

A polishing composition according to this example was prepared in the same manner as in Example 1 except that PACMO was not used.

### <Polishing of Silicon Wafer>

The contents of the stock polishing step applied to each example are described hereinbelow.

### (Stock Polishing Step)

A stock polishing composition containing 0.95% of an abrasive and 0.065% of a basic compound, with the balance being water, was prepared. Colloidal silica having a BET diameter of 35 nm was used as the abrasive. Potassium hydroxide (KOH) was used as the basic compound.

Using this stock polishing composition as it was as a polishing slurry (working slurry), a silicon wafer as an object to be polished was polished under the following stock polishing conditions. As the silicon wafer, a commercially available silicon single crystal wafer (conductivity type: P type, crystal orientation: <100>, resistivity: 1 Ω·cm or more and less than 100 Ω·cm, COP-free) having a diameter of 300 mm after lapping and etching was used.

### [Stock Polishing Conditions]

Polishing machine: Single wafer polishing machine manufactured by Okamoto Machine Tool Works, Ltd., model "PNX-332B"
Polishing pressure: 19 kPa
Platen rotational speed: 32 rpm
Head (carrier) rotational speed: 30 rpm
Polishing pad: manufactured by Fujibo Ehime Co., Ltd., product name "SUBA400"
Flow rate of polishing slurry: 1 L/min
Temperature of polishing slurry: 20°C
Temperature of platen cooling water: 20°C
Polishing time: 2 min 30 sec

Each of the polishing compositions according to the Examples was used as it was as a polishing slurry (working slurry), and the silicon wafer after the stock polishing step was polished under the following final polishing conditions.

### [Final Polishing Conditions]

Polishing machine: Single wafer polishing machine manufactured by Okamoto Machine Tool Works, Ltd., model "PNX-332B"
Polishing pressure: 16 kPa
Platen rotational speed: 26 rpm
Head (carrier) rotational speed: 25 rpm
Polishing pad: manufactured by Fujibo Ehime Co., Ltd., product name "POLYPAS27NX" Flow rate of polishing slurry: 0.5 L/min
Temperature of polishing slurry: 20°C
Temperature of platen cooling water: 20°C
Polishing time: 2 min 30 sec

The polished silicon wafer was removed from the polishing machine and cleaned (SC-1 Cleaning) using a cleaning solution of NH₄OH (29%):H₂O₂ (31%):deionized water (DIW) = 2:5.3:48 (volume ratio). More specifically, a cleaning tank equipped with an ultrasonic oscillator with a frequency of 720 kHz was prepared, the cleaning solution was accommodated in the cleaning tank and held at 60°C, and the polished silicon wafer was immersed in the cleaning tank for 6 min and then rinsed with ultrapure water. After the step was repeated twice, the silicon wafer was dried.

### <Haze Measurement

For the surface of the silicon wafer after cleaning, haze (ppm) was measured in a DWO mode using a wafer defect tester ("Surfscan SP2^{XP}" (trade name) manufactured by KLA-Tencor Corporation). The obtained result was converted into a relative value with the haze number of Example 4 being taken as 100, and is shown in Table 1.

### [Table 1]

**Table 1**

| | Water-soluble polymer | | | | Surfactant | | | | Evaluation |
|---|---|---|---|---|---|---|---|---|---|
| | PVA | | Other | | Fitrst surfactant | | Second surfactant | | Haze [%] |
| | Degree of acetalization [mol%] | Content [wt%] | Type | Content [wt%] | Type | Content [wt%] | Type | Content [wt%] | |
| Ex.1 | 30 | 0.0050 | PACMO | 0.0038 | C10PEO5 | 0.0008 | - | - | 97 |
| Ex.2 | 10 | 0.0050 | PACMO | 0.0038 | C10PEO5 | 0.0008 | - | - | 95 |
| Ex.3 | 20 | 0.0050 | PACMO | 0.0038 | C10PEO5 | 0.0008 | - | - | 97 |
| Ex.4 | 30 | 0.0050 | PACMO | 0.0038 | C10PEO5 | 0.0008 | C12PEO18-SO3NH3 | 0.0002 | 95 |
| Ex.5 | 30 | 0.0050 | PACMO | 0.0038 | C10PEO5 | 0.0008 | PEO-PPO-PEO | 0.0004 | 91 |
| Ex.6 | 0 | 0.0050 | PACMO | 0.0038 | C10PEO5 | 0.0008 | - | - | 100 |
| Ex.7 | 30 | 0.0050 | - | - | C10PEO5 | 0.0008 | - | - | 111 |

As shown in Table 1, the polishing compositions of Examples 1 to 5 in which the acetalized polyvinyl alcohol-based polymer and PACMO were used in combination all showed excellent haze reducing capability. Here, comparing Examples 1 to 3 in which acetalized polyvinyl alcohol was used and Example 6 in which a non-acetalized polyvinyl alcohol-based polymer was used instead of the acetalized polyvinyl alcohol-based polymer, since the polishing compositions of Examples 1 to 3 showed excellent haze reducing capability, the superiority of using an acetalized polyvinyl alcohol-based polymer as the water-soluble polymer in terms of haze reducing capability was demonstrated. In addition, the haze reducing capability was confirmed regardless of the degree of acetalization. Comparing Examples 1 to 3 including PACMO in addition to the acetalized polyvinyl alcohol polymer and Example 7 including no water-soluble polymer other than the acetalized polyvinyl alcohol polymer, it was shown that the haze reducing capability was significantly improved as a result of using PACMO in addition to the acetalized polyvinyl alcohol polymer.

Further, the polishing compositions of Examples 4 and 5 in which two kinds of surfactants were used in combination showed better haze reducing capability as compared with Example 1 in which one kind of surfactant was used. Among them, the polishing composition of Example 5 in which C10PEO5 having an Mw of 378 and PEO-PPO-PEO having an Mw of 3200 were used in combination exhibited particularly excellent haze reducing capability.

Although specific examples of the present invention have been described in detail above, they are merely examples and do not limit the scope of the claims. The techniques described in the claims include those in which the specific examples exemplified above are variously modified and changed.

## Claims

1. A polishing composition comprising an abrasive, a basic compound, a water-soluble polymer, and water, wherein
the water-soluble polymer includes at least a water-soluble polymer P1 and a water-soluble polymer P2,
the water-soluble polymer P1 is an acetalized polyvinyl alcohol-based polymer, and
the water-soluble polymer P2 is a water-soluble polymer other than the acetalized polyvinyl alcohol-based polymer.

2. The polishing composition according to claim 1, wherein the water-soluble polymer P1 is an acetalized polyvinyl alcohol-based polymer having a degree of acetalization of 1 mol% or more and less than 60 mol%.

3. The polishing composition according to Claim 1 or 2, wherein the water-soluble polymer P2 is one or two or more kinds selected from the group consisting of a nitrogen atom-containing polymer, a non-acetalized polyvinyl alcohol-based polymer, an oxyalkylene unit-containing polymer, a starch derivative, and a cellulose derivative.

4. The polishing composition according to any one of Claims 1 to 3, further comprising a surfactant.

5. The polishing composition according to Claim 4, wherein the surfactant includes two or more kinds of surfactants selected from the group consisting of nonionic surfactants and anionic surfactant.

6. The polishing composition according to Claim 4 or 5, wherein the surfactant includes a surfactant Sf_{S} having a weight average molecular weight of less than 1000 and a surfactant Sf_{L} having a weight average molecular weight of 1000 or more.

7. The polishing composition according to any one of Claims 1 to 6, wherein the water-soluble polymer P1 has a weight average molecular weight of 10 × 10⁴ or less.

8. The polishing composition according to any one of Claims 1 to 7, wherein the abrasive is a silica particle.

9. The polishing composition according to any one of Claims 1 to 8, which is used for polishing a surface of silicon.
